Europäisches Patentamt

European Patent Office

Office européen des brevets

(19)

(11) **EP 1 413 024 B1**

(12) **EUROPÄISCHE PATENTSCHRIFT**

(45) Veröffentlichungstag und Bekanntmachung des Hinweises auf die Patenterteilung:
**29.12.2004 Patentblatt 2004/53**

(21) Anmeldenummer: **01978104.6**

(22) Anmeldetag: **05.09.2001**

(51) Int Cl.⁷: **H01S 5/0683**

(86) Internationale Anmeldenummer:
**PCT/DE2001/003468**

(87) Internationale Veröffentlichungsnummer:
**WO 2003/017441 (27.02.2003 Gazette 2003/09)**

(54) **VERFAHREN UND VORRICHTUNG ZUR REGELUNG EINES LASERS**

METHOD AND DEVICE FOR ADJUSTING A LASER

PROCEDE ET DISPOSITIF DESTINE AU REGLAGE D'UN LASER

(84) Benannte Vertragsstaaten:
**DE FR GB**

(30) Priorität: **03.08.2001 DE 10138474**

(43) Veröffentlichungstag der Anmeldung:
**28.04.2004 Patentblatt 2004/18**

(73) Patentinhaber: **Infineon Technologies AG**
**81669 München (DE)**

(72) Erfinder:
• **AURACHER, Franz**
**82065 Baierbrunn (DE)**

• **SCHOLZ, Robert**
**14052 Berlin (DE)**

(74) Vertreter:
**Müller, Wolfram Hubertus, Dipl.-Phys. et al**
**Patentanwälte**
**Maikowski & Ninnemann,**
**Postfach 15 09 20**
**10671 Berlin (DE)**

(56) Entgegenhaltungen:
EP-A- 0 539 038          US-A- 5 402 433
US-A- 5 488 621          US-A- 5 850 409

**Beschreibung**

Die Erfindung betrifft ein Verfahren und eine Vorrichtung zur Regelung eines Lasers.

Aus der US-A-5 850 409 ist es bekannt, mit einer Monitordiode gewandelte Meßsignale zur Regelung der Laserleistung und der Ausgangsamplitude der modulierten optischen Daten rückzukoppeln. Dabei wird einem Datensignal ein Pilotton mit einer relativ niedrigen Frequenz und einer gegenüber dem Datensignal niedrigen Amplitude überlagert. Die Ausgangsamplitude der modulierten Daten wird auf einen konstanten Wert geregelt. Hierzu wird die Amplitude des Pilottons auf einen konstanten Bruchteil des Modulationsstromes eingestellt, so daß die optische Ausgangsleistung ein konstanter Bruchteil der Amplitude der optischen Daten mit der Frequenz des Pilottons ist. Mittels einer Rückkopplung wird der Modulationsstrom geregelt, so daß auch die optische Amplitude der gesendeten Daten auf einen gewünschten Wert geregelt werden kann.

Eine zweite Rückkopplungsschleife wird genutzt, um die mittlere optische Ausgangsleistung des Lasers auf einen festen Wert zu regeln. Hierzu wird $I_{BIAS}$ derart geregelt, dass unabhängig von der Lasersteilheit und somit der Temperatur bzw. Alterung die mittlere optische Leistung $P_0$ konstant ist. Beide Regelprinzipien zusammen gewährleisten ein konstantes Extinktionsverhältnis ER.

Dieses Regelprinzip weist jedoch folgende Nachteile für direkt modulierte Laser bei hohen Datenraten auf:

1. Damit der Laser eine ausreichende Modulationsbandbreite erzielt, muss $I_{BIAS}$ - $I_{th}$, d.h. die Differenz zwischen dem Vorstrom und dem Schwellstrom des Lasers, relativ hoch gewählt werden, beispielsweise 30 bis 50 mA, so dass sich bereits relativ hohe Laserströme ergeben. Mit zunehmender Temperatur und Alterung sinkt die Lasersteilheit und der Schwellstrom steigt an. Bei Regelung auf konstante Leistung muss die geringere Lasersteilheit durch eine wesentliche Erhöhung des Laserstroms ausgeglichen werden.

Dies kann sehr rasch dazu führen, dass der maximal verfügbare oder zulässige Laserstrom überschritten würde. Außerdem ist dann für ein konstantes Extinktionsverhältnis eine sehr große Modulationsamplitude $I_{mod}$ erforderlich, was wiederum bei hohen Datenraten schwierig zu erreichen ist und darüberhinaus zu unerwünschten Relaxationsschwingungen bei dem High Level "1" führt.

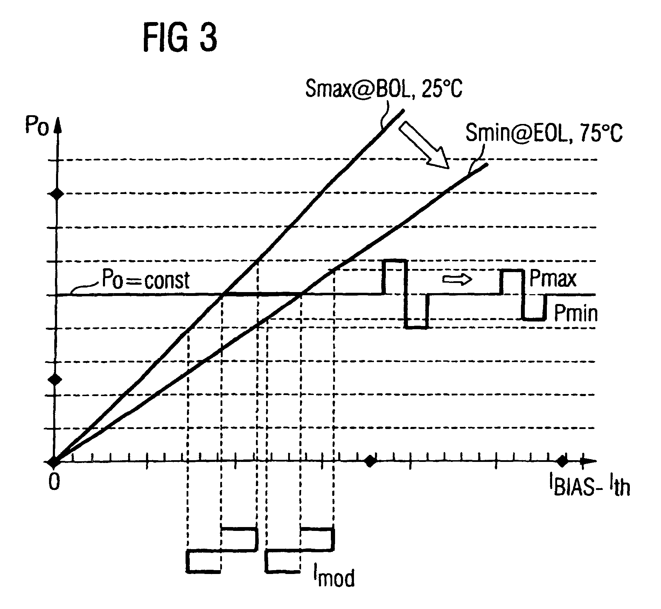

Diese Zusammenhänge sind in der Figur 3 dargestellt, in der die Leistung $P_0$ einer Laserdiode in Abhängigkeit von der Differenz $I_{BIAS}$ - $I_{th}$ aufgetragen ist. Smax gibt die maximale Steilheit der Laserdiode beim Lebensbeginn (BOL-Begin of Life) und bei niedriger Temperatur (25°C) an, Smin die minimale Steilheit der Laserdiode am Lebensende (EOL-End of Life) und bei hoher Temperatur (75°C) an. Der Modulationsstrom eines Datensignals ist mit Imod angegeben.

Aus Figur 3 ist zum einen unmittelbar ersichtlich, daß bei einer Steuerung auf $P_0$ = konstant eine abnehmende Lasersteilheit zu einem geringeren Extinktionsverhältnis ET = Pmax/Pmin führt. Dies kann zwar durch Erhöhung der Modulationsstroms Imod ausgeglichen werden; eine alterungsbedingte Änderung des Extinktionsverhältnisses ER ist in der Regel jedoch nicht vermeidbar. Dies hat aber zur Folge, daß zunächst ein sehr hoher Wert von ER am Lebensbeginn (BOL) vorliegen muß, um das geforderte ER am Lebensende (EOL) noch garantieren zu können. Ein hohes Extinktionsverhältnis führt nachteilig jedoch zu starken Relaxationsschwingungen des Lasers.

Zum anderen ist aus Figur 3 ersichtlich, daß bei abnehmender Lasersteilheit für eine Regelung auf konstante Leistung $P_0$ der Laserstrom erheblich erhöht werden muß.

2. Die Regelung auf konstante Leistung ist relativ ungenau, da sich das Verhältnis von Detektorstrom der Monitordiode zur Leistung in der Faser über der Temperatur und durch Alterung ändert. Dies gilt in besonderem Maße für die üblicherweise für hohe Datenraten verwendeten DFB-Lasermodule und dem üblichen Aufbau, bei dem die Monitordiode die aus der rückwärtigen Facette austretende Strahlung misst. Dies führt dazu, dass bei der Fertigung der Lasermodule, insbesondere der Faserankopplung, die Steilheit extrem genau eingehalten werden muss.

Im übrigen sind für einen Laser und einen Regler sehr enge Toleranzen einzuhalten, um den Betrieb eines Lasers innerhalb vorgegebener Spezifikationsgrenzen wie maximale und minimale optische Leistung, maximalen BIAS-Strom, Temperaturbereich, Exktinktionsverhältnis und Frequenzgang zu ermöglichen.

Der Erfindung stellt sich daher die Aufgabe, ein neues Regelungsverfahren anzugeben, das die Neigung eines Lasers zu Relaxationsschwingungen reduziert, ohne den Aufwand für eine Kühlung des Lasers zu erhöhen, und dadurch insbesondere die direkte Modulation eines Halbleiterlasers im ungekühlten Zustand selbst bei hohen Datenraten im Bereich von 10Gbit/s ermöglicht.

Diese Aufgabe wird durch ein Verfahren zur Regelung eines Lasers mit den Merkmalen des Patentanspruchs 1 und durch eine Vorrichtung zur Regelung eines Lasers mit den Merkmalen des Patentanspruchs 14 gelöst. Vorteilhafte Weiterbildungen der Erfindung sind den Unteransprüchen zu entnehmen.

Demgemäß wird der Arbeitspunkt eines durch ein Datensignal modulierbaren Lasers geregelt. Das Regelungsverfahren wird vorzugsweise für Halbleiterlaserdioden angewendet. Eine bevorzugte Anwendung liegt in Low-Cost Lösungen für einkanalige Datenübertragungen auf kurzen Strecken von beispielsweise 10 bis 20 km.

Der Arbeitspunkt des Lasers wird dadurch geregelt, daß ein Gleichstrom, der den Laser durchfließt, gesteuert wird, wobei der Gleichstrom mit optischen Eigenschaften des Lasers korreliert. Eine optische Eigenschaft ist beispielsweise die Grenzfrequenz der Modulation, die optische Ausgangsleistung oder die Steilheit der Laserdiode.

Zur Regelung wird der Gleichstrom oberhalb eines veränderlichen Schwellstromes gesteuert, so daß die möglichen Arbeitspunkte des Lasers für einen Gleichstrom größer als der Schwellstrom wählbar sind. Zur Regelung des Arbeitspunktes wird ein aus der Differenz des Gleichstromes und des Schwellstromes definierter Differenzstrom oder eine zum Differenzstrom korrelierende Größe auf einen konstanten Wert geregelt, wobei der konstante Wert allerdings temperaturabhängig sein kann. Der Gleichstrom kann demzufolge für einen festgelegten Arbeitspunkt variieren.

Die erfindungsgemäße Lösung einer Regelung von $I_{BIAS}$ - $I_{th}$ auf einen konstanten bzw. lediglich von der Temperatur abhängigen Wert weist folgende Vorteile auf:

1. Für alle Betriebsbedingungen kann ein relativ hoher Wert von $I_{BIAS}$ - $I_{th}$ gewählt werden, wodurch eine große Modulationsbandbreite bereitgestellt wird.

2. Es kann durch eine temperaturabhängige Steuerung von $I_{BIAS}$ - $I_{th}$ die Modulationsbandbreite weitgehend temperaturunabhängig gehalten werden. Die Modulationsbandbreite (auch als Übertragungsbandbreite bezeichnet) sinkt mit steigender Temperatur und steigt mit $I_{BIAS}$ - $I_{th}$. Der Abfall der Modulationsbandbreite mit steigender Temperatur kann somit durch Erhöhung der Differenz $I_{BIAS}$ - $I_{th}$ kompensiert werden.

3. Da die Regelung sehr genau ist, kann bei der Faserankopplung eine größere Toleranz der erzielten Steilheit in der Faser (gleich optische Leitung in der Faser / ($I_{BIAS}$ - $I_{th}$)) zugelassen werden.

Die erfindungsgemäße Lösung sieht also vor, die Differenz von Biasstrom und Schwellstrom des Lasers auf einen konstanten oder temperaturabhängigen Wert zu regeln. Lediglich im einfachsten Fall wird der Wert von $I_{BIAS}$ - $I_{th}$ dabei auf einen festen, temperaturunabhängigen Wert geregelt. Eine temperaturabhängige Regelung, d.h. eine Regelung von $I_{BIAS}$ - $I_{th}$ auf einen von der Temperatur abhängigen Wert wird bevorzugt, um die mit steigender Temperatur abnehmende Modulationsbandbreite des Lasers durch Erhöhen des Wertes $I_{BIAS}$ - $I_{th}$ auszugleichen. Damit dennoch das Extinktionsverhältnis gleich bleibt, ist es erforderlich, auch die Amplitude des Modulationsstroms temperaturabhängig zu steuern. So ist das Extinktionsverhältnis abhängig von $I_{BIAS}$ - $I_{th}$ und bei konstantem Wert von $I_{BIAS}$ - $I_{th}$ und konstanter Amplitude des Modulationsstroms ebenfalls konstant. Um ein konstantes Extinktionsverhältnis auch bei einer temperaturabhängigen Regelung des Wertes $I_{BIAS}$ - $I_{th}$ zu gewährleisten, wird die Amplitude des Modulationsstroms entsprechend dem Wert von $I_{BIAS}$ - $I_{th}$ geändert.

In einer bevorzugten Ausgestaltung der Erfindung wird die Laserdiode zusätzlich zum Gleichstrom mit einem einen Wechselanteil aufweisenden Pilotsignal beaufschlagt. Das Pilotsignal ist im einfachsten Fall ein Wechselstrom mit einer gegenüber der Modulationsfrequenz um Größenordnungen niedrigeren Frequenz und geringerer Amplitude. Es können aber auch alle anderen zur Bestimmung der optischen Eigenschaft des Lasers geeignete Pilotsignale, wie ein Burst oder gepulste Signale verwendet werden. Beide Ströme mit Gleichanteil und Wechselanteil werden insbesondere durch dieselben Elektroden der Laserdiode gespeist, oder alternativ mittels mehrerer Elektroden in unterschiedlichen Richtungen durch die Laserdiode geleitet. Das durch den Gleichstrom, das Pilotsignal und das Datensignal erzeugte Licht der Laserdiode wird erfaßt und ausgewertet und der Gleichstrom in Abhängigkeit von dieser Auswertung gesteuert.

Eine Weiterbildung dieser Ausgestaltung umfaßt Empfangsmittel, insbesondere eine Monitordiode, und Auswertemittel, die zur Auswertung ein mit dem Gleichstrom korrelierendes Gleichmeßsignal und ein mit dem Pilotsignal korrelierendes Wechselmeßsignal bestimmen. Bevorzugterweise sind die Meßsignale dem Gleichstrom beziehungsweise der Amplitude des Pilotsignals proportional.

Zur Regelung wird in einer bevorzugten Ausgestaltung der Erfindung das Verhältnis von dem Gleichmeßsignal (entsprechend der optischen Durchschnittsleistung der Monitordiode) zu der Amplitude des Wechselmeßsignals (entsprechend der optischen Leistung des Pilotsignals) gebildet. Die Amplitude des Wechselmeßsignals ist dabei ein Maß für die Lasersteilheit. Das Gleichmeßsignal ist proportional der optischen Durchschnittsleistung des Lasers. Durch Verhältnisbildung der beiden Leistungen bzw. der entsprechenden Ströme der Monitordiode ist der Wert von $I_{BIAS}$ - $I_{th}$ bestimmbar.

Es wird bei dem erfindungsgemäßen Regelkonzept somit der Quotient aus DC- und AC-Signal der Monitordiode gebildet. Dies weist den Vorteil auf, dass eine Änderung der Monitordiodensteilheit keine Rolle spielt. Insbesondere sind die Meßsignale aufgrund der Verhältnisbildung unabhängig von einer Drift des Meßgeräts.

Die Amplitude des Wechselmeßsignals ($I_{MDac}$) wird bevorzugt durch Multiplikation des Wechselmeßsignals ($I_{MDac}$) mit dem Pilotsignal ($I_{LDAC}$) und anschließende Integration gebildet (Synchron- oder Lock-In Detektion). Die Amplitude des Pilotsignales steht durch die Steuerung des Pilotstromes als Steuergröße zur Verfügung. Das Verhältnis von dem Gleichmeßsignal zu der Amplitude des Wechselmeßsignals wird mit dem konstanten Wert oder einer davon abgeleiteten Größe, der bzw. die den Arbeitspunkt charakterisiert, zur Auswertung verglichen. Die abgeleitete Größe ist beispielsweise mit dem konstanten Wert über einen Algorithmus verbunden, im einfachsten Fall zum konstanten Wert proportional.

In Abhängigkeit von diesem Vergleich wird der Gleichstrom derart geregelt oder gesteuert, daß das Ergebnis und der konstante Wert bzw. die abgeleitete Größe im wesentlichen übereinstimmen, und damit der Differenzstrom auf den konstanten oder temperaturabhängigen Wert geregelt wird. Hierdurch wird der durch diese Übereinstimmung im wesentlichen festgelegte Arbeitspunkt innerhalb kleiner Abweichungen gehalten.

Dieses Verfahren ermöglicht die Regelung des Differenzstromes, ohne den Schwellstrom explizit messen zu müssen.

Die Erfindung wird im folgenden anhand eines Ausführungsbeispiels unter Bezugnahme auf Zeichnungen näher erläutert. Dabei zeigen:

FIG 1       einen schematischen Schaltplan einer Regelungsvorrichtung,

FIG 2a      eine Kennlinie einer Laserdiode,

FIG 2b      eine Übertragungskennlinie zwischen einer Laserdiode und einer Monitordiode,

FIG 2c      einen Ausschnitt aus dem schematischen Schaltplan aus FIG 1 und

FIG 3       die Leistung $P_0$ einer Laserdiode in Abhängigkeit von der Differenz $I_{BIAS}$ - $I_{th}$ bei einer im Stand der Technik bekannten Regelung auf konstante Leistung einer Laserdiode.

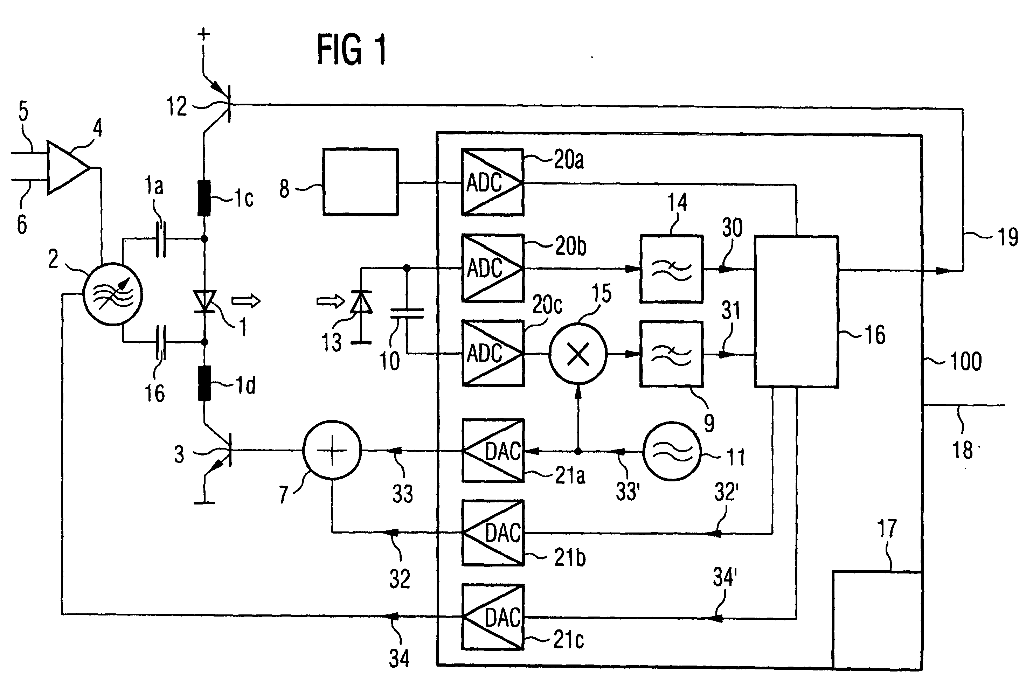

Gemäß Figur 1 ist eine Laserdiode 1 über eine optische Verbindung mit einer Monitordiode 13 gekoppelt. Ein von der Laserdiode 13 ausgesendetes, optisches Signal wird über die optische Kopplung teilweise auf die Monitordiode 13 übertragen und in ein elektrisches Monitorsignal, beispielsweise einen Monitorstrom gewandelt. Weiterhin ist die Laserdiode thermisch mit einem Temperatursensor 8 gekoppelt, der die aktuelle Temperatur der Laserdiode in ein elektronisches Signal wandelt.

Die Monitordiode 13 und der Temperatursensor 8 sind mit einem Mikrocontroller 100 verbunden, der die elektrischen Signale auswertet. Der Mikrocontroller 100 weist zudem analoge und digitale Steuerausgänge auf, die mit Peripherieelementen der Laserdiode 1 in Wirkverbindung stehen. Über die Steuerleitung 19 steuert der Mikrocontroller 100 einen PNP-Schalttransistor 12, so daß der Laserstrom der Laserdiode 1 im Falle einer Überhitzung mittels dieser Sicherheitsschaltung abschaltbar ist.

Der durch den Schalttransistor 12 schaltbare Laserstrom fließt durch Induktivitäten 1c und 1d, durch die Laserdiode 1 und durch eine Stromsenke 3, die durch einen NPN-Bipolartransistor 3 gebildet ist. Die Induktivitäten 1c, 1d verhindern eine Dämpfung von hochfrequenten Modulationssignalen durch parasitäre Kapazitäten der Transistoren 3 und 12. Weiterhin ist die Laserdiode 1 zur Modulation von hochfrequenten Daten über zwei Kondensatoren 1a und 1b kapazitiv mit dem Modulator 2 verbunden. Der Dateneingang des Modulators 2 wird mit Daten durch die Eingangsstufe 4 gespeist, die einen invertierenden Eingang 5 und einen nicht-invertierenden Eingang 6 aufweist.

Zur Einstellung der Amplitude der Modulation ist der Modulator 2 über eine Steuerleitung mit dem Steuersignal 34 mit dem Mikrocontroller 100 verbunden. Ein Steuereingang der Stromsenke 3 ist mit einem Addierer 7 verbunden. Alternativ zu der Darstellung der Figur 1 kann der Addierer 7 auch integraler Bestandteil des Mikrocontrollers 100 sein.

Der Mikrokontroller 100 weist mehrerer analoge Eingänge auf, die die analogen Signale mit Hilfe von Analog-Digital-Umsetzern 20a, 20b, 20c in digitale Signale wandeln, die wiederum von einer digitalen Recheneinheit des Mikrocontrollers 100 unter Abarbeitung eines entsprechenden Programmes ausgewertet werden. Anhand der Auswertungsergebnisse werden wiederum digitale Steuersignale generiert, die mittels Digital-Analog-Umsetzer 21a, 21b, 21c als analoge Ausgangsgrößen die Steuereingänge der Peripherieelemente 2, 3, 12 der Laserdiode 1 steuern. Alternativ zu dem in Figur 1 schematisch dargestellten Schaltkreis können die Funktionen des Mikrocontrollers 100 auch durch einen rein analogen Schaltkreis realisiert werden.

Einige Regelungselemente des Mikrocontrollers 100 sind in der Figur 1 innerhalb des Mikrocontrollers 100 separat dargestellt, obwohl diese einfacherweise in einer Recheneinheit mittels eines Programmablaufes generiert werden können. So weist der Mikrocontroller 100 einen Regler, z.B. einen Proportional-Integral-Regler 16 (PI-Regler) auf, der ein BIAS-Signal 32' in den Digital-Analog-Umsetzer 21b einlädt. Dieses BIAS-Signal gelangt als analoges BIAS-Signal 32 über eine Steuerleitung auf den Addierer 7. Zusätzlich wird im Mikrocontroller 100 in einem Oszillator 11 ein niederfrequentes Pilotsignal 33' mit einer Frequenz von beispielsweise 500 Hz und einer gegenüber dem Modulationssignal kleinen Amplitude generiert. Dieses Pilotsignal 33' wird über den Digital-Analog-Umsetzer 21a in ein analoges Pilotsignal 33 gewandelt und ebenfalls dem Addierer 7 zugeführt.

Die vom Addierer 7 addierten Signale werden auf den Steuereingang der Stromsenke 3 übertragen und generieren einen zum BIAS-Signal korrelierenden BIAS-Gleichstrom ($I_{BIAS}$) und einen zum Pilotsignal 33 korrelierenden Wechselstrom ($I_{LDac}$) durch die Laserdiode 1. Diese Ströme werden von der Laserdiode 1 über die optische Kopplung an die Monitordiode 13 übertragen. Der mit der Monitordiode 13 verbundene Kondensator 10 filtert den Gleichanteil ($I_{MDdc}$) des Monitorsignals heraus.

Der verbleibende Wechselsignalanteil ($I_{MDac}$) wird mittels des Analog-Digital-Umsetzers 20c in ein digitales Wechselsignal ($I_{MDac}$) gewandelt. Vorteilhafterweise wird, jedoch in Figur 1 nicht dargestellt, zuvor das Modulationssignal ausgefiltert. Das digitale Wechselsignal ($I_{MDac}$) wird im Mischer 15 mit dem Pilotsignal 33' gemischt. Im Frequenzmischer 15 werden die beiden Signale zur Mischung beispielsweise miteinander multipliziert, so daß Frequenzanteile, die von der Pilotfrequenz abweichen, sowie Gleichanteile, sich nicht auswirken (Synchrongleichrichter). Die Ausgangssignale des Frequenzmischers 15 werden einem ersten Tiefpaß 9 oder Integrator 9 zugeführt. Die Eckfrequenz des Tiefpasses 9 oder Integrators 9 ist dabei wesentlich niedriger als die Pilotfrequenz, so daß dem PI-Regler ein im wesentlichen geglättetes, zur Amplitude des Wechselsignals ($I_{MDac}$) korrelierendes Signal 31 zur Verfügung gestellt wird.

Der Analog-Digital-Umsetzer 20b wandelt dagegen auch den Gleichanteil ($I_{MDdc}$) des Monitorsignals. Wiederum ist die Eckfrequenz des Tiefpasses 14 oder Integrators 14 deutlich niedriger als die Pilotfrequenz des Pilotsignales 33, so daß die Anteile des Pilotsignales ausgefiltert werden. Dem PI-Regler wird demzufolge ein im wesentlichen geglättetes, zum Wert des Gleichsignals ($I_{MDdc}$) korrelierendes Signal 30 zur Verfügung gestellt. Weiterhin ist der PI-Regler 16 über den Analog-Digital-Umsetzer 20a mit dem Temperatursensor 8 verbunden.

Um von weiteren Funktionseinheiten aus auf die Regelung oder Schaltung der Laserströme Einfluß zu nehmen, ist der Mikrocontroller 100 mit einer externen Datenverbindung 18, beispielsweise mit einem BUS-System 18 verbunden. Zusätzlich weist der Mikrocontroller 100 einen nicht-flüchtigen Speicher 17 auf, um die Regelparameter und Startparameter zur Regelung zu speichern oder um neue Spezifikationen des Lasers hinzuzufügen.

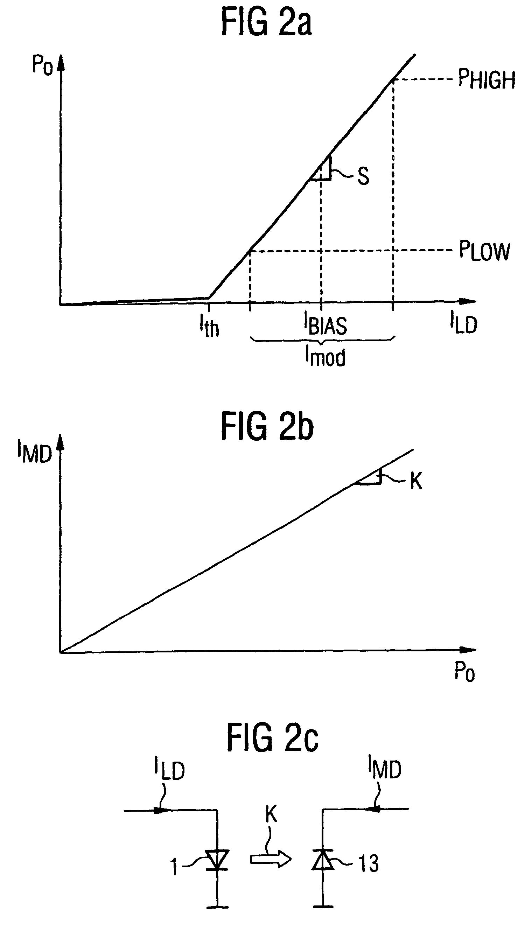

Die Kennlinie der Laserdiode 1 ist in Figur 2a dargestellt. In diesem Fall ist die optische Leistung $P_O$ über dem Laserdiodenstrom $I_{LD}$ aufgetragen. Die Laserdiode 1 beginnt erst oberhalb eines Schwellstromes $I_{th}$ wesentlich optische Leistung zu emittieren. Die Laserdiode 1 wird in einem Arbeitspunkt für den Laserdiodenstromwert $I_{BIAS}$ betrieben. Um diesen Arbeitspunkt erfolgt die Modulation der Laserdiode 1, mit den Zuständen $P_{HIGH}$ und $P_{LOW}$, entsprechend dem zugehörigen Modulationsstrom $I_{mod}$.

In Figur 2b ist die Übertragungsfunktion der Monitordiode 13 mit dem Monitorstrom $I_{MD}$ über der optischen Leistung $P_O$ aufgetragen. K ist der Kopplungsfaktor zwischen der optischen Leistung $P_o$ und dem Monitorstrom $I_{MD}$.

Figur 2c zeigt einen Ausschnitt des schematischen Schaltplans der Figur 1. Die Laserdiode 1 wird über den Laserdiodenstrom $I_{LD}$ gespeist. Mittels der optischen Kopplung K wird ein Teil der abgestrahlten optischen Energie auf die Monitordiode 13 übertragen, die einen zur optischen Leistung korrelierenden Monitorstrom $I_{MD}$ zieht.

Im folgenden wird eine einfache mathematische Herleitung der Regelungsgrundlagen erläutert.

Die Steilheit S der Laserdiode 1 ist gemäß Figur 2a für einen Laserstrom $I_{LD}$ größer als der Schwellstrom $I_{th}$ gegeben durch:

$$S = \frac{\Delta P_O}{\Delta I_{LD}} \qquad \text{für } I_{LD} \geq I_{th} \tag{1}$$

Für einen gegebenen Arbeitspunkt gilt beispielsweise:

$$S = \frac{P(I_{LD}) - P(I_{th})}{I_{LD} - I_{th}} \tag{2}$$

Dabei sind weder die Steilheit S noch der Schwellstrom $I_{th}$ über die Lebensdauer des Laser konstant. Zudem sind beide Werte temperaturabhängig. Unter der Annahme, daß für Ströme kleiner oder gleich dem Schwellstrom die optische Leistung $P_O$ zu vernachlässigen ist, gilt folglich:

$$P(I_{th}) = 0 \text{ so daß } S = \frac{P(I_{LD})}{I_{LD} - I_{th}} \tag{3}$$

Oder nach entsprechender Umformung für den entsprechenden Arbeitspunkt gilt:

$$I_{LD} - I_{th} = \frac{P_O}{S} \tag{4}$$

Um den Laser im optimalen Arbeitspunkt zu betreiben, sollte der Differenzstrom $I_{diff} = I_{LD} - I_{th}$ auf einen konstanten bzw. temperaturabhängigen Wert geregelt werden. Dies bereitet insofern Schwierigkeiten, da der Schwellstrom während des Betriebes nur schwer bestimmbar ist. Beispielsweise könnte hierzu in Pausen zwischen den zu übertragenen Daten der Schwellstrom $I_{th}$ ausgemessen werden, jedoch ist das optisches Verhalten beim erneuten Überschreiten des Schwellstromes $I_{th}$ nicht hinreichend. Daher wird im folgenden ein anderes besonders vorteilhaftes Verfahren zur Regelung dargelegt.

Über den Koppelfaktor K werden Größen der Laserdiode 1 in entsprechende Meßsignale der Monitordiode 13 umgerechnet.

$$P_O = \frac{I_{MDdc}}{K} \qquad [5]$$

Betrachtet man das Wechselstromsignal des Pilotsignals, so gilt in Verbindung mit Gleichung 1 analog:

$$S = \frac{I_{MDac}}{K \cdot I_{LDac}} \qquad [6]$$

Dabei ist $I_{MDac}$ die Amplitude des Wechselmeßsignals der Monitordiode. $I_{Ldac}$ ist die Amplitude des Pilotsignals.

Werden die beiden Gleichungen 5 und 6 in die Gleichung 4 eingesetzt, so folgt:

$$\frac{P_O}{S} = \frac{\frac{1}{K} \cdot I_{MDdc}}{\frac{1}{K} \cdot I_{MDac} \cdot \frac{1}{I_{LDac}}} \qquad [7]$$

Für den Arbeitspunkt wird

$$I_{BIAS} = I_{LD}|_{AP} \qquad [8]$$

gesetzt. Dies bedeutet, daß beispielsweise entgegen des aus der US 5,850,409 bekannten Regelungsprinzip die Amplitude des Pilottons auf einen festen Wert eingestellt wird. Folglich gilt als Ausgangsgleichung für die Regelung:

$$I_{BIAS} - I_{th} = \frac{I_{MDdc}}{I_{MDac}} \cdot I_{LDac} \qquad [9]$$

Der Differenzstrom $I_{diff}$ ist somit gleich dem linken oder rechten Teil der Gleichung 9. Zur Regelung wird demzufolge das Verhältnis von dem Gleichmeßsignal $I_{MDdc}$ zu der Amplitude des Wechselmeßsignals $I_{MDac}$ mit der Amplitude des Pilotsignals $I_{LDac}$ multipliziert. Das Ergebnis der Multiplikation wird mit dem konstanten Wert $I_{diff}$ oder einer davon abgeleiteten Größe, der bzw. die den Arbeitspunkt in ähnlicher Weise charakterisiert, zur Auswertung verglichen. In Abhängigkeit von diesem Vergleich wird der Gleichstrom derart geregelt oder gesteuert, daß das Ergebnis des rechten Terms der Gleichung und der konstante Wert von $I_{diff}$ im wesentlichen übereinstimmen und geringe Abweichungen entsprechend ausgeregelt werden, indem der Biasstrom $I_{BIAS}$ nachgeführt wird.

Der Wert für den Differenzstrom $I_{diff}$ wird vorteilhafterweise derart festgelegt, daß dieser Wert einem Arbeitspunkt des Lasers 1 im Bereich einer vorgegebenen, minimalen Übertragungsbandbreite B für Modulationssignale entspricht. So soll vorteilhafterweise sichergestellt werden, dass unabhängig vom Alter des Lasers 1 eine minimale Übertragungsbandbreite B zur Verfügung steht und die übertragenen Signale nicht durch eine unzureichende Übertragungsbandbreite verzerrt oder stark gedämpft werden. Dies ist in vielen Fällen wichtiger, als eine möglichst konstante optische Ausgangsleistung.

Da insbesondere die Übertragungsbandbreite und andere Kenngrößen des Lasers temperaturabhängig sind, wird der vorgegebene Regelwert von dem Differenzstrom $I_{diff}$ in Abhängigkeit von der jeweils aktuellen Temperatur des Lasers 1 beispielsweise aus empirisch ermittelten und gespeicherten Werten bestimmt. Alternativ kann auch ein Algorithmus zur optimalen Berechnung des Differenzstromes $I_{diff}$ in Abhängigkeit von der Temperatur und gegebenenfalls weiterer Einflußgrößen berechnet werden. Es erfolgt somit eine temperaturabhängige Steuerung der Differenz von $I_{BIAS}$ - $I_{th}$. Dadurch wird auch bei sich ändernden Temperaturen eine ausreichende Übertragungsbandbreite des Lasers erzielt. Durch bevorzugte gleichzeitige Steuerung des Modulationsstroms entsprechend dem Wert von $I_{BIAS}$ - $I_{th}$ wird gleichzeitig ein konstantes Extinktionsverhältnis gewährleistet.

Alternativ oder zusätzlich zur Anpassung des vorgegebenen Wertes der Differenzstromes $I_{diff}$ wird in einer vorteilhaften Ausgestaltung der Erfindung der Wert für die Amplitude des Pilotsignal $I_{LDac}$ vorgegeben.

Obwohl die mittlere optische Ausgangsleistung in Abhängigkeit von dem Biasstrom $I_{BIAS}$ variiert, kann das Extinktionsverhältnis weitestgehend konstant geregelt werden. Für das Extinktionsverhältnis ER gilt:

$$ER = \frac{P_{HIGH}}{P_{LOW}} = \frac{S(I_{BIAS} - I_{th}) + \frac{I_{mod}}{2}}{S(I_{BIAS} - I_{th}) - \frac{I_{mod}}{2}} = \frac{(I_{BIAS} - I_{th}) + \frac{I_{mod}}{2}}{(I_{BIAS} - I_{th}) - \frac{I_{mod}}{2}} \qquad [10]$$

S kürzt sich dabei heraus.

Aus (10) folgt, daß, wenn die Werte $I_{BIAS}$ - $I_{th}$ und $I_{mod}$ konstant sind, dann auch das Extinktionsverhältnis ER konstant ist. $I_{mod}$ ist dabei die Amplitude des Modulationssignals.

Wird jedoch vorteilhafterweise der Wert $I_{BIAS}$ - $I_{th}$ mit steigender Temperatur angehoben, um den Abfall der Laserbandbreite mit steigender Temperatur auszugleichen, dann wird zweckmäßigerweise die Amplitude des Modulationsstroms Imod im gleichen Verhältnis wie $I_{BIAS}$ - $I_{th}$ angehoben, damit das Extinktionsverhältnis ER konstant bleibt. Hierzu wird ein temperaturabhängiges Steuersignal 34 zur Einstellung der Amplitude der Modulation bzw. des Modulationshubs an den Modulator 2 übertragen (vgl. Fig. 1).

Die Regelung des Differenzstromes $I_{diff}$ oder einer hierzu korrelierenden Größe und die Regelung des Extinktionsverhältnisses ER sollten nicht dazu führen, daß der Laser 1 außerhalb seiner Spezifikationsgrenzen betrieben wird. Hierzu wird zusätzlich überwacht, dass die mittlere optische Leistung innerhalb eines Leistungsfensters oberhalb eines unteren Schwellwertes für eine für den Betrieb des Lasers minimal notwendige Leistung und unterhalb eines oberen Schwellwertes gehalten wird. Der obere Schwellwert bewirkt, daß der Gleichstrom $I_{BIAS}$ in Abhängigkeit von einer optischen Leistung Po des Lasers 1 derart begrenzt wird, daß die optische Leistung Po einen Maximalwert nicht überschreitet. Dies ist insbesondere für Sicherheitsaspekte wichtig, so daß durch die Begrenzung der Leistung die Gefahr einer Verletzung der Augen reduziert wird.

**Patentansprüche**

1. Verfahren zur Regelung des Arbeitspunktes eines mit einem Datensignal modulierten Lasers (1), bei dem ein Gleichstrom $I_{BIAS}$ des Lasers (1) gesteuert wird, der mit optischen Eigenschaften des Lasers (1) korreliert, wobei

- der Gleichstrom $I_{BIAS}$ oberhalb eines veränderlichen Schwellstromes $I_{th}$ gesteuert und
- ein aus der Differenz des Gleichstromes $I_{BIAS}$ und des Schwellstromes $I_{th}$ definierter Differenzstrom $I_{diff}$, oder eine zum Differenzstrom $I_{diff}$ korrelierende Größe auf einen konstanten oder lediglich von der Temperatur abhängigen Wert geregelt wird.

2. Verfahren nach Anspruch 1,
**dadurch gekennzeichnet, daß**
der genannte Wert einem Arbeitspunkt des Lasers (1) im Bereich einer vorgegebenen, minimalen Übertragungsbandbreite für Modulationssignale entspricht.

3. Verfahren nach Anspruch 1 oder 2,
**dadurch gekennzeichnet, daß**
der genannte Wert vorgegeben wird in Abhängigkeit von

a) der Temperaturabhängigkeit einer optischen Kenngröße des Lasers (1) und
b) von der Temperatur des Lasers (1).

4. Verfahren nach Anspruch 3,
**dadurch gekennzeichnet, daß**

die optische Kenngröße die Übertragungsbandbreite der Modulationssignale ist.

5. Verfahren nach einem der vorhergehenden Ansprüche,
**dadurch gekennzeichnet, daß** durch Mittel (100, 7, 3, 13, 10)

- die Laserdiode (1) zusätzlich mit einem einen Wechselanteil aufweisenden Pilotsignal $I_{LDAC}$ beaufschlagt wird,
- das durch den Gleichstrom $I_{BIAS}$ und das Pilotsignal $I_{LDAC}$ erzeugte Licht der Laserdiode (1) erfaßt und ausgewertet und
- der Gleichstrom $I_{BIAS}$ in Abhängigkeit von dieser Auswertung gesteuert wird.

6. Verfahren nach den Ansprüchen 3 und 5,
**dadurch gekennzeichnet, daß**
der genannte Wert durch eine temperaturabhängige Steuerung des Pilotsignals $I_{LDAC}$ vorgegeben wird.

7. Verfahren nach einem der Ansprüche 5 oder 6,
**dadurch gekennzeichnet, daß**
zur Auswertung ein mit dem Gleichstrom $I_{BIAS}$ korrelierendes Gleichmeßsignal $I_{MDdc}$ und ein mit dem Pilotsignal $I_{LDAC}$ korrelierendes Wechselmeßsignal $I_{MDac}$ bestimmt werden.

8. Verfahren nach Anspruch 7,
**dadurch gekennzeichnet, daß** durch Mittel (100, 7, 3, 13, 10)

- das Verhältnis von dem Gleichmeßsignal $I_{MDdc}$ zu der Amplitude des Wechselmeßsignals $I_{MDac}$ und das Ergebnis mit dem konstanten Wert oder einer davon abgeleiteten Größe, der bzw. die den Arbeitspunkt charakterisiert, zur Auswertung verglichen wird, und
- in Abhängigkeit von diesem Vergleich der Gleichstrom $I_{BIAS}$ derart geregelt oder gesteuert wird, daß das Ergebnis und der konstante Wert bzw. die abgeleitete Größe im wesentlichen übereinstimmen.

9. Verfahren nach Anspruch 8,
**dadurch gekennzeichnet, daß** die Amplitude des Wechselmeßsignals $I_{MDac}$ durch Multiplikation des Wechselmeßsignals $I_{MDac}$ mit dem Pilotsignal $I_{LDAC}$ und anschließende Integration gebildet wird.

10. Verfahren nach Anspruch 8 oder 9,
**dadurch gekennzeichnet, daß**
das Verhältnis ER von einem oberen Modulationspegel $P_{HIGH}$ zu einem unteren Modulationspegel $P_{LOW}$ auf einen konstanten Wert geregelt wird.

11. Verfahren nach einem der vorhergehenden Ansprüche,
**dadurch gekennzeichnet, daß**
der Gleichstrom $I_{BIAS}$ in Abhängigkeit von einem Vergleich eines Verhältnisses ER von einem oberen Modulationspegel $P_{HIGH}$ zu einem unteren Modulationspegel $P_{LOW}$ mit einem unteren Schwellwert derart geregelt wird, daß das Verhältnis ER diesen unteren Schwellwert nicht unterschreitet.

12. Verfahren nach einem der vorhergehenden Ansprüche,
**dadurch gekennzeichnet, daß**
der Gleichstrom $I_{BIAS}$ in Abhängigkeit von einer optischen Leistung $P_O$ des Lasers (1) derart begrenzt wird, daß die optische Leistung $P_O$ einen Maximalwert nicht überschreitet.

13. Verfahren nach Anspruch 1,
**dadurch gekennzeichnet, daß**

- durch einen Mikrocontroller (100) ein Pilotsignal $I_{LDac}$ und der Gleichstrom $I_{BIAS}$ gesteuert wird, indem ein Treiber (3) zum Steuern der Summe der Ströme $I_{BIAS}$ und $I_{LDac}$ von dem Mikrocontroller (100) angesteuert wird,
- die Laserdiode (1) ein zu der Summe der Ströme $I_{BIAS}$ und $I_{LDac}$ korrelierendes Licht emittiert, das von einer Monitordiode (13) in einen Monitorstrom $I_{MD}$ gewandelt wird, der ein mit dem Gleichstrom $I_{BIAS}$ korrelierendes Gleichmeßsignal $I_{MDdc}$ und ein mit dem Pilotsignal $I_{LDAC}$ korrelierendes Wechselsignal $I_{MDac}$ aufweist,
- das Wechselsignal durch eine Trenneinrichtung (10) vom Gleichmeßsignal $I_{MDdc}$ getrennt wird,
- das Wechselsignal analog-digital umgesetzt wird,

- das umgesetzte Wechselsignal mit dem Pilotsignal $I_{LDac}$ gemischt wird,
- das Mischsignal aus dem umgesetzten Wechselsignal und dem Pilotsignal $I_{LDac}$ zu einem zur Amplitude des Wechselsignals korrelierenden Wechselmeßsignal $I_{MDac}$ integriert wird,
- das Wechselsignal aus dem Monitorstrom mittels einer weiteren Integration gefiltert wird, so daß das Gleichmeßsignal $I_{MDdc}$ ausgewertet wird,
- das Verhältnis von dem Gleichmeßsignal $I_{MDdc}$ zu der Amplitude des Wechselmeßsignals $I_{MDac}$ mit der Amplitude des Pilotsignals $I_{LDAC}$ multipliziert und das Ergebnis mit dem konstanten Wert des Differenzstromes $I_{diff}$ oder einer davon abgeleiteten Größe, der bzw. die den Arbeitspunkt charakterisiert, zur Auswertung verglichen wird, und
- in Abhängigkeit von diesem Vergleich der Gleichstrom $I_{BIAS}$ derart geregelt oder gesteuert wird, daß das Ergebnis und der konstante Wert bzw. die abgeleitete Größe im wesentlichen übereinstimmen, wobei
- dieser konstante Wert einem Arbeitspunkt des Lasers (1) im Bereich einer vorgegebenen, minimalen Übertragungsbandbreite für Modulationssignale entspricht.

**14.** Vorrichtung zur Regelung eines Laser (1) mit

- einem Treiber (3) zur Regelung eines Gleichstroms $I_{BIAS}$, der mit optischen Eigenschaften des Lasers (1) korreliert,
- Mitteln (100, 13, 10) zur Berechnung eines durch eine Differenz aus dem Gleichstrom $I_{BIAS}$ und einem Schwellstrom $I_{th}$ definierten Differenzstromes $I_{diff}$, oder einer zum Differenzstrom $I_{diff}$ korrelierenden Größe, und

Mitteln (100, 7, 3) zur Regelung des Differenzstroms $I_{diff}$ oder der zum Differenzstrom $I_{diff}$ korrelierenden Größe auf einen konstanten oder lediglich von der Temperatur abhängigen Wert.

**15.** Vorrichtung nach Anspruch 14,
**dadurch gekennzeichnet, daß**
eine Monitordiode (13) das von der Laserdiode (1) erzeugte Licht anteilig erfaßt und der Wechselstromanteil des Monitordiodenstroms von dem Gleichstromanteil durch eine mit der Monitordiode (13) verbundene Kapazität (10) trennbar ist.

**16.** Vorrichtung nach Anspruch 15,
**dadurch gekennzeichnet, daß**
ein Mikrocontroller (100) mit Analog-Digital-Umsetzern (20a, 20b, 20c) für analoge Eingänge und Digital-Analog-Umsetzern (21a, 21b, 21c) für analoge Ausgänge vorgesehen ist, dessen einer oder mehrere analoge Ausgänge zur Steuerung des Gleichstroms $I_{BIAS}$ und des Pilotsignals $I_{LDac}$ mit dem Treiber (3) oder mit einem mit dem Treiber (3) verbundenen Addierer (7) verbunden sind, und dessen analoge Eingänge mit der Monitordiode (13), der Kapazität (10) und einem Temperatursensor (8) verbunden sind.

**17.** Vorrichtung nach Anspruch 16,
wobei die Laserdiode (1) ein zu der Summe der Ströme $I_{BIAS}$ und $I_{LDac}$ korrelierendes Licht emittiert, das von der Monitordiode (13) in einen Monitorstrom $I_{MD}$ gewandelt wird, der ein mit dem Gleichstrom $I_{BIAS}$ korrelierendes Gleichmeßsignal $I_{MDdc}$ und ein mit dem Pilotsignal $I_{LDAC}$ korrelierendes Wechselsignal $I_{MDac}$ aufweist,
**dadurch gekennzeichnet, daß** vorgesehen sind:

eine Trennvorrichtung (10), die das Wechselsignal vom Gleichmeßsignal $I_{MDdc}$ trennt,
Umsetzmittel (20c), die das Wechselsignal analog-digital umsetzen,
Integrationsmittel (9), die ein Mischsignal aus dem umgesetzten Wechselsignal und dem Pilotsignal $I_{LDac}$ zu einem zur Amplitude des Wechselsignals korrelierenden Wechselmeßsignal $I_{MDac}$ integrieren, Filtermittel (10, 14), die das Wechselsignal aus dem Monitorstrom filtern, so daß das Gleichmeßsignal $I_{MDdc}$ ausgewertet wird,
einen Regler (16), der das Verhältnis von dem Gleichmeßsignal $I_{MDdc}$ zu der Amplitude des Wechselmeßsignals $I_{MDac}$ mit der Amplitude des Pilotsignals $I_{LDAC}$ multipliziert und das Ergebnis mit dem konstanten Wert des Differenzstromes $I_{diff}$ oder einer davon abgeleiteten Größe, der bzw. die den Arbeitspunkt charakterisiert, zur Auswertung vergleicht und der in Abhängigkeit von diesem Vergleich den Gleichstrom $I_{BIAS}$ derart regelt oder steuert, daß das Ergebnis und der konstante Wert bzw. die abgeleitete Größe im wesentlichen übereinstimmen.

**Claims**

1. Method for regulating the operating point of a laser (1) modulated with a data signal, in which a direct current $I_{BIAS}$ of the laser (1) is controlled, which current correlates with optical properties of the laser (1),

   - the direct current $I_{BIAS}$ being controlled above a variable threshold current $I_{th}$, and
   - a differential current $I_{diff}$ defined from the difference between the direct current $I_{BIAS}$ and the threshold current $I_{th}$ or a variable correlating with the differential current $I_{diff}$ being regulated to a constant value or one which is only dependent on temperature.

2. Method according to Claim 1,
   **characterized in that**
   the aforementioned value corresponds to an operating point of the laser (1) in the region of a predetermined minimum transmission bandwidth for modulation signals.

3. Method according to Claim 1 or 2,
   **characterized in that**
   the aforementioned value is predetermined in a manner dependent on

   a) the temperature dependence of an optical characteristic variable of the laser (1) and
   b) on the temperature of the laser (1).

4. Method according to Claim 3,
   **characterized in that**
   the optical characteristic variable is the transmission bandwidth of the modulation signals.

5. Method according to one of the preceding claims,
   **characterized in that**, by means (100, 7, 3, 13, 10),

   - a pilot signal $I_{LDAC}$ having an AC component is additionally applied to the laser diode (1),
   - the light of the laser diode (1) generated by the direct current $I_{BIAS}$ and the pilot signal $I_{LDAC}$ is detected and evaluated, and
   - the direct current $I_{BIAS}$ is controlled in a manner dependent on this evaluation.

6. Method according to Claims 3 and 5,
   **characterized in that**
   the aforementioned value is predetermined by a temperature-dependent control of the pilot signal $I_{LDAC}$.

7. Method according to either of Claims 5 or 6,
   **characterized in that**
   a DC measurement signal $I_{MDdc}$ correlating with the direct current $I_{BIAS}$ and an AC measurement signal $I_{MDac}$ correlating with the pilot signal $I_{LDAC}$ are determined for the evaluation.

8. Method according to Claim 7,
   **characterized in that**, by means (100, 7, 3, 13, 10)

   - the ratio of the DC measurement signal $I_{MDdc}$ to the amplitude of the AC measurement signal $I_{MDac}$ and the result is compared with the constant value or a variable derived therefrom, which characterizes the operating point, for the evaluation and
   - in a manner dependent on this comparison, the direct current $I_{BIAS}$ is regulated or controlled in such a way that the result and the constant value or the derived variable essentially correspond.

9. Method according to Claim 8,
   **characterized in that** the amplitude of the AC measurement signal $I_{MDac}$ is formed by multiplication of the AC measurement signal $I_{MDac}$ by the pilot signal $I_{LDAC}$ and subsequent integration.

10. Method according to Claim 8 or 9,
    **characterized in that**

the ratio ER of an upper modulation level $P_{HIGH}$ to a lower modulation level $P_{LOW}$ is regulated to a constant value.

**11.** Method according to one of the preceding claims,
**characterized in that**
the direct current $I_{BIAS}$ is regulated in a manner dependent on a comparison of a ratio ER of an upper modulation level $P_{HIGH}$ to a lower modulation level $P_{LOW}$ with a lower threshold value in such a way that the ratio ER does not fall below said lower threshold value.

**12.** Method according to one of the preceding claims,
**characterized in that**
the direct current $I_{BIAS}$ is limited in a manner dependent on optical power $P_0$ of the laser (1) in such a way that the optical power $P_0$ does not exceed a maximum value.

**13.** Method according to Claim 1,
**characterized in that**

- a pilot signal $I_{LDac}$ and the direct current $I_{BIAS}$ are controlled by a microcontroller (100) by a driver (3) for controlling the sum of the currents $I_{BIAS}$ and $I_{LDac}$ being driven by the microcontroller (100),
- the laser diode (1) emits a light which correlates with the sum of the currents $I_{BIAS}$ and $I_{LDac}$, and a monitor diode (13) converts said light into a monitor current $I_{MD}$ having a DC measurement signal $I_{MDdc}$ correlating with the direct current $I_{BIAS}$ and an AC signal $I_{MDac}$ correlating with the pilot signal $I_{LDAC}$,
- the AC signal is separated from the DC measurement signal $I_{MDdc}$ by a separating device (10),
- the AC signal is subjected to analogue-to-digital conversion,
- the converted AC signal is mixed with the pilot signal $I_{LDac}$,
- the mixed signal comprising the converted AC signal and the pilot signal $I_{LDac}$ is integrated to form an AC measurement signal $I_{MDac}$ correlating with the amplitude of the AC signal,
- the AC signal is filtered from the monitor current by means of a further integration so that the DC measurement signal $I_{MDdc}$ is evaluated,
- the ratio of the DC measurement signal $I_{MDdc}$ to the amplitude of the AC measurement signal $I_{MDac}$ is multiplied by the amplitude of the pilot signal $I_{LDAC}$ and the result is compared with the constant value of the differential current $I_{diff}$ or a variable derived therefrom, which characterizes the operating point, for the evaluation and
- in a manner dependent on this comparison, the direct current $I_{BIAS}$ is regulated or controlled in such a way that the result and the constant value or the derived variable essentially correspond,
- said constant value corresponding to an operating point of the laser (1) in the region of a predetermined minimum transmission bandwidth for modulation signals.

**14.** Device for regulating a laser (1) having

- a driver (3) for regulating a direct current $I_{BIAS}$, which correlates with optical properties of the laser (1),
- means (100, 13, 10) for calculating a differential current $I_{diff}$ defined by a difference from the direct current $I_{BIAS}$ and a threshold current $I_{th}$ or a variable correlating with the differential current $I_{diff}$, and
means (100, 7, 3) for regulating the differential current $I_{diff}$ or the variable correlating with the differential current $I_{diff}$ to a constant value or one which is only dependent on temperature.

**15.** Device according to Claim 14,
**characterized in that**
a monitor diode (13) proportionally detects the light generated by the laser diode (1) and the AC current component of the monitor diode current can be separated from the DC current component by a capacitance (10) connected to the monitor diode (13).

**16.** Device according to Claim 15,
**characterized in that**
a microcontroller (100) having analogue-to-digital converters (20a, 20b, 20c) for analogue inputs and digital-to-analogue converters (21a, 21b, 21c) for analogue outputs is provided, one or a plurality of whose analogue outputs, for controlling the direct current ($I_{BIAS}$) and the pilot signal ($I_{LDac}$) are connected to the driver (3) or to an adder (7) connected to the driver (3), and whose analogue inputs are connected to the monitor diode (13), the capacitance (10) and a temperature sensor (8).

**17.** Device according to Claim 16,
the laser diode (1) emitting a light which correlates with the sum of the currents $I_{BIAS}$ and $I_{LDac}$, and the monitor diode (13) converting said light into a monitor current $I_{MD}$ having a DC measurement signal $I_{MDdc}$ correlating with the direct current $I_{BIAS}$ and an AC signal $I_{MDac}$ correlating with the pilot signal $I_{LDAC}$,
**characterized in that** the following are provided:

a separating device (10), which separates the AC signal from the DC measurement signal $I_{MDdc}$,
conversion means (20c) which subject the AC signal to analogue-to-digital conversion,
integration means (9), which integrate a mixed signal comprising the converted AC signal and the pilot signal $I_{LDac}$ to form an AC measurement signal $I_{MDac}$ correlating with the amplitude of the AC signal,
filter means (10, 14), which filter the AC signal from the monitor current so that the DC measurement signal $I_{MDdc}$ is evaluated,
a regulator (16), which multiplies the ratio of the DC measurement signal $I_{MDdc}$ to the amplitude of the AC measurement signal $I_{MDac}$ by the amplitude of the pilot signal $I_{LDAC}$ and compares the result with the constant value of the differential current $I_{diff}$ or a variable derived therefrom which characterizes the operating point, for the evaluation and which, in a manner dependent on this comparison, regulates or controls the direct current $I_{BIAS}$ in such a way that the result and the constant value or the derived variable essentially correspond.


**Revendications**

**1.** Procédé de réglage du point de fonctionnement d'un laser (1) modulé avec un signal de données, dans lequel on commande un courant continu $I_{BIAS}$ du laser (1) qui est corrélé à des propriétés optiques du laser (1) et dans lequel

- on commande le courant continu $I_{BIAS}$ au-dessus d'un courant de seuil $I_{th}$ variable, et
- on règle un courant différentiel $I_{diff}$, défini par la différence entre le courant continu $I_{BIAS}$ et le courant de seuil $I_{th}$, ou une grandeur corrélée au courant différentiel $I_{diff}$ sur une valeur constante ou dépendante seulement de la température.

**2.** Procédé selon la revendication 1,
**caractérisé par le fait que** la valeur mentionnée correspond à un point de fonctionnement du laser (1) dans le domaine d'une largeur de bande de transmission minimale prédéterminée pour des signaux de modulation.

**3.** Procédé selon la revendication 1 ou 2,
**caractérisé par le fait qu'**on prescrit la valeur mentionnée en fonction

a) de la dépendance à la température d'une grandeur caractéristique optique du laser (1), et
b) de la température du laser (1).

**4.** Procédé selon la revendication 3,
**caractérisé par le fait que** la grandeur caractéristique optique est la largeur de bande de transmission des signaux de modulation.

**5.** Procédé selon l'une des revendications précédentes, **caractérisé par le fait que**, par des moyens (100, 7, 3, 13, 10),

- la diode laser (1) reçoit en plus un signal pilote $I_{LDAC}$ comportant une composante alternative,
- la lumière, produite par le courant continu $I_{BIAS}$ et par le signal pilote $I_{LDAC}$, de la diode laser (1) est détectée et évaluée, et
- le courant continu $I_{BIAS}$ est commandé en fonction de cette évaluation.

**6.** Procédé selon les revendications 3 et 5,
**caractérisé par le fait qu'**on prescrit la valeur mentionnée en commandant le signal pilote $I_{LDAC}$ en fonction de la température.

**7.** Procédé selon l'une des revendications 5 ou 6,
**caractérisé par le fait que**, pour l'évaluation, on détermine un signal de mesure continu $I_{MDdc}$ corrélé au courant continu $I_{BIAS}$ et un signal de mesure alternatif $I_{MDac}$ corrélé au signal pilote $I_{LDAC}$.

**8.** Procédé selon la revendication 7,
   **caractérisé par le fait que**, par des moyens (100, 7, 3, 13, 10),

   - on compare pour l'évaluation le rapport du signal de mesure continu $I_{MDdc}$ à l'amplitude du signal de mesure alternatif $I_{MDac}$ à la valeur constante ou à une grandeur déduite de celle-ci caractérisant le point de fonctionnement, et
   - on règle ou commande le courant continu $I_{BIAS}$ de telle sorte en fonction de cette comparaison que le résultat et la valeur constante ou la grandeur déduite coïncident globalement.

**9.** Procédé selon la revendication 8,
   **caractérisé par le fait qu'**on forme l'amplitude du signal de mesure alternatif $I_{MDac}$ par multiplication du signal de mesure alternatif $I_{MDac}$ par le signal pilote $I_{LDAC}$ et par intégration consécutive.

**10.** Procédé selon la revendication 8 ou 9,
   **caractérisé par le fait qu'**on règle le rapport ER d'un niveau de modulation supérieur $P_{HIGH}$ à un niveau de modulation inférieur $P_{LOW}$ sur une valeur constante.

**11.** Procédé selon l'une des revendications précédentes,
   **caractérisé par le fait qu'**on règle le courant continu $I_{BIAS}$ en fonction d'une comparaison entre un rapport ER d'un niveau de modulation supérieur $P_{HIGH}$ à un niveau de modulation inférieur $P_{LOW}$ et une valeur de seuil inférieure de telle sorte que le rapport ER ne dépasse pas cette valeur de seuil inférieure.

**12.** Procédé selon l'une des revendications précédentes,
   **caractérisé par le fait qu'**on limite le courant continu $I_{BIAS}$ en fonction d'une puissance optique $P_0$ du laser (1) de telle sorte que la puissance optique $P_0$ ne dépasse pas une valeur maximale.

**13.** Procédé selon la revendication 1,
   **caractérisé par le fait que**

   - un signal pilote $I_{LDac}$ et le courant continu $I_{BIAS}$ sont commandés par un microcontrôleur (100), un circuit d'attaque (3) pour la commande de la somme des courants $I_{BIAS}$ et $I_{LDac}$ étant commandé par le microcontrôleur (100),
   - la diode laser (1) émet une lumière qui est corrélée à la somme des courants $I_{BIAS}$ et $I_{LDac}$ et qui est transformée par une diode de moniteur (13) en un courant de moniteur $I_{MD}$ qui comporte un signal de mesure continu $I_{MDdc}$ corrélé au courant continu $I_{BIAS}$ et un signal alternatif $I_{MDac}$ corrélé au signal pilote $I_{LDAC}$,
   - le signal alternatif est séparé du signal de mesure continu $I_{MDdc}$ par un dispositif séparateur (10),
   - le signal alternatif est soumis à une conversion analogique-numérique,
   - le signal alternatif converti est mélangé au signal pilote $I_{LDac}$,
   - le signal mélangé constitué du signal alternatif converti et du signal pilote $I_{LDac}$ est intégré en un signal de mesure alternatif $I_{MDac}$ corrélé à l'amplitude du signal alternatif,
   - le signal alternatif est filtré hors du courant de moniteur au moyen d'une autre intégration de telle sorte que le signal de mesure continu $I_{MDdc}$ est évalué,
   - le rapport du signal de mesure continu $I_{MDdc}$ à l'amplitude du signal de mesure alternatif $I_{MDac}$ est multiplié par l'amplitude du signal pilote $I_{LDAC}$ et le résultat est comparé pour l'évaluation à la valeur constante du courant différentiel $I_{diff}$ ou à une grandeur déduite de celle-ci caractérisant le point de fonctionnement, et
   - le courant continu $I_{BIAS}$ est réglé ou commandé en fonction de cette comparaison de telle sorte que le résultat et la valeur constante ou la grandeur déduite coïncident globalement,
   - cette valeur constante correspondant à un point de fonctionnement du laser (1) dans le domaine d'une largeur de bande de transmission minimale prédéterminée pour des signaux de modulation.

**14.** Dispositif de réglage d'un laser (1) comportant :

   - un circuit d'attaque (3) pour le réglage d'un courant continu $I_{BIAS}$ qui est corrélé à des propriétés optiques du laser (1),
   - des moyens (100, 13, 10) pour le calcul d'un courant différentiel $I_{diff}$ défini par une différence entre le courant continu $I_{BIAS}$ et un courant de seuil $I_{th}$ ou d'une grandeur corrélée au courant différentiel $I_{diff}$, et
   - des moyens (100, 7, 3) pour le réglage du courant différentiel $I_{diff}$ ou de la grandeur corrélée au courant différentiel $I_{diff}$ sur une valeur constante ou dépendante seulement de la température.

**15.** Dispositif selon la revendication 14,

**caractérisé par le fait qu'**une diode de moniteur (13) détecte les composantes de la lumière produite par la diode laser (1) et que la composante de courant alternatif du courant de diode de moniteur est séparable de la composante de courant continu par une capacité (10) reliée à la diode de moniteur (13).

**16.** Dispositif selon la revendication 15,

**caractérisé par le fait qu'**il est prévu un microcontrôleur (100), avec des convertisseurs analogiques-numériques (20a, 20b, 20c) pour des entrées analogiques et avec des convertisseurs numériques-analogiques (21a, 21b, 21c) pour des sorties analogiques, dont une ou plusieurs sorties analogiques sont reliées pour la commande du courant continu $I_{BIAS}$ et du signal pilote $I_{LDac}$ au circuit d'attaque (3) ou à un additionneur (7) relié au circuit d'attaque (3) et dont les entrées analogiques sont reliées à la diode de moniteur (13), à la capacité (10) et à un capteur de température (8).

**17.** Dispositif selon la revendication 16,

dans lequel la diode laser (1) émet une lumière qui est corrélée à la somme des courants $I_{BIAS}$ et $I_{LDac}$ et qui est transformée par la diode de moniteur (13) en un courant de moniteur $I_{MD}$ qui comporte un signal de mesure continu $I_{MDdc}$ corrélé au courant continu $I_{BIAS}$ et un signal alternatif $I_{MDac}$ corrélé au signal pilote $I_{LDAC}$,

**caractérisé par le fait qu'**il est prévu :

- un dispositif séparateur (10) qui sépare le signal alternatif du signal de mesure continu $I_{MDdc}$,
- des moyens de conversion (20c) qui soumettent le signal alternatif à une conversion analogique-numérique,
- des moyens d'intégration (9) qui intègrent un signal mélangé constitué du signal alternatif converti et du signal pilote $I_{LDac}$ en un signal de mesure alternatif $I_{MDac}$ corrélé à l'amplitude du signal alternatif,
- des moyens de filtrage (10, 14) qui filtrent le signal alternatif hors du courant de moniteur de telle sorte que le signal de mesure continu $I_{MDdc}$ est évalué,
- un régleur (16) qui multiplie le rapport du signal de mesure continu $I_{MDdc}$ à l'amplitude du signal de mesure alternatif $I_{MDac}$ par l'amplitude du signal pilote $I_{LDAC}$ et qui compare pour l'évaluation le résultat à la valeur constante du courant différentiel $I_{diff}$ ou d'une grandeur déduite de celle-ci caractérisant le point de fonctionnement et qui règle ou commande le courant continu $I_{BIAS}$ de telle sorte en fonction de cette comparaison que le résultat et la valeur constante ou la grandeur déduite coïncident globalement.

FIG 1

EP 1 413 024 B1

# FIG 2a

# FIG 2b

# FIG 2c

FIG 3